# EUROPEAN PATENT SPECIFICATION

(11) **EP 2 051 302 B1**
(45) Date of publication and mention of the grant of the patent: **07.07.2010**
(21) Application number: 08253312.6
(22) Date of filing: 10.10.2008
(51) Int. Cl.: H01L 27/12, H01L 21/77

(54) **Active matrix substrate and electronic display device**
Aktives Matrixsubstrat und elektronische Anzeigevorrichtung
Substrat de matrice active et dispositif d'affichage électronique

(30) Priority: 17.10.2007 JP 2007270023
(43) Date of publication of application: 22.04.2009
(60) Divisional application: 10005362.8
(73) Proprietor: Ricoh Company, Ltd., Tokyo 143-8555 (JP)
(72) Inventor: Onodera, Atsushi, Tokyo (JP); Yutani, Keiichiro, Yokohama-shi, Kanagawa (JP)
(74) Representative: Leeming, John Gerard

(56) References cited:
- WO-A-2006/064443
- JP-A- 3 033 724
- JP-A- 2005 012 181
- JP-A- 2005 310 962
- JP-A- 2006 343 768
- US-A1- 2003 173 629
- US-A1- 2004 001 167
- US-A1- 2007 164 282

## Description

The present invention relates to an active matrix substrate and an electronic display device having the active matrix substrate.

Many electronic display devices such as liquid crystal display devices and organic EL display devices use an active matrix substrate as their drive unit. A drive circuit formed on the active matrix,substrate is a small and precise multilayer circuit. Methods of forming a circuit pattern with functional materials (such as electrodes, signal lines, insulators, and semiconductors) on the drive circuit are roughly divided into two groups, namely, a group of photolithographic methods and a group of printing methods.

The photolithographic methods are based on an optical pattern forming method and therefore are excellent in forming a very fine and precise circuit patterns. The photolithographic methods have often been used for forming a circuit pattern on the active matrix substrate for use in the liquid crystal display devices and the organic EL display devices. The photolithographic methods, however, require large equipment and involve many processing steps. Moreover, because the circuit pattern is formed by removing unnecessary portions, the material used for the removed portions is wasted. This not only reduces, in principle, the use efficiency of the material but also causes a problem of disposal of the waste material.

On the other hand, the printing methods such as an inkjet method, a gravure method, a flexographic printing method, and a screen printing method form a pattern by applying predetermined amounts of printing inks containing functional materials to predetermined positions. The printing methods have an advantage over the photolithographic methods in that the printing methods require no large equipment, involve a small number of steps, offer high material use efficiency, and produce a small amount of waste.

The printing methods are superior to the photolithographic methods in reducing the cost of forming a circuit pattern on the active matrix substrate but is not sufficient to form a fine pattern. For example, in the case where the inkjet method of the printing methods is used, ink droplets may spread excessively on the substrate or may aggregate to form a cluster. This makes it difficult to form a very fine pattern.

Japanese Patent Laid-Open Publication No. 2005-12181 (corresponding to Japanese Patent Registration No. 3788467) (Patent Document 1) discloses a method that solves these problems. The disclosed method processes, before ejecting ink droplets, the surface of a substrate on which a pattern is to be formed in order to control the surface structure of the substrate with respect to the ink droplets, and then ejects ink droplets to form a pattern. More specifically, banks (barriers) are formed on non-ink deposition regions. Ink droplets are then deposited into a groove defined between the banks, which prevent the ink from flowing out of the groove. According to this method, the wettablities of the banks and the groove with respect to the ink droplets may be controlled.

Japanese Patent Laid-Open Publication No. 2005-310962 (Patent Document 2) discloses a method that forms an ink wettable region and an ink repellent by processing the surface of a substrate on which a pattern is to be formed and selectively deposits ink droplets onto the ink wettable region only. The ink droplets deposited on the ink wettable region spread within the ink wettable region and does not cross the border with the ink repellent region. Thus a fine pattern can be formed.

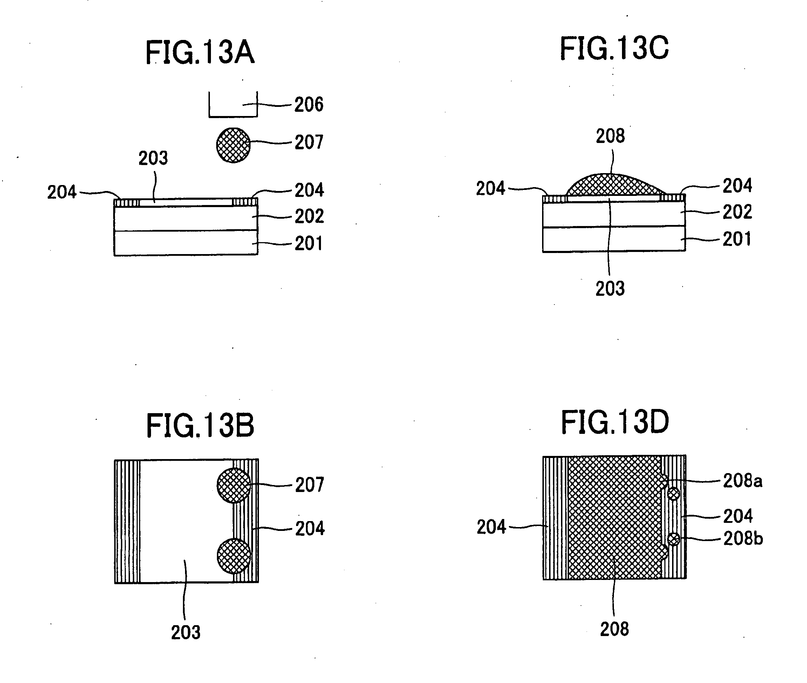

The techniques disclosed in Patent Document 1 and 2 can prevent excessive spread of ink droplets and aggregation of ink droplets and therefore can form a fine print pattern with the functional materials. However, referring to FIGS. 13A - 13D, if ink droplets 207 (FIG. 13B) are deposited onto a region (the bank of Patent Document 1 and the ink repellent region of Patent Document 2) on which the ink droplets 207 are not supposed to be deposited, ink portions 208a and 208b (FIG. 13D) remain on the region even after the ink is dry. The inkjet method has limited droplet deposition accuracy in depositing ink droplets onto the substrate due to the ink droplet ejection accuracy in ejecting ink droplets from nozzles and the positioning accuracy of a stage supporting the substrate onto which ink droplets are to be deposited. Accordingly, even if the substrate to be printed is processed in various ways as disclosed in Patent Documents 1 and 2, it is difficult to form a pattern having a width less than the diameter of the ink droplets. The diameter of the ink droplets and the ink droplet deposition accuracy need to be taken into consideration to form patterns with high yield. Since a typical inkjet method uses a droplet diameter at least in the range of 10 - 20 µm or greater, it is difficult to form a pattern of a width less than this range. That is, it is difficult to form a fine pattern having a width as small as 1 µm which is achieved by the photolithographic methods. Although the inkjet method is discussed above, the minimum pattern width achieved by the other printing methods is also about a few tens of micrometers. That is, it is very difficult to form a pattern having a width of a few tens of micrometers or less using the other printing methods.

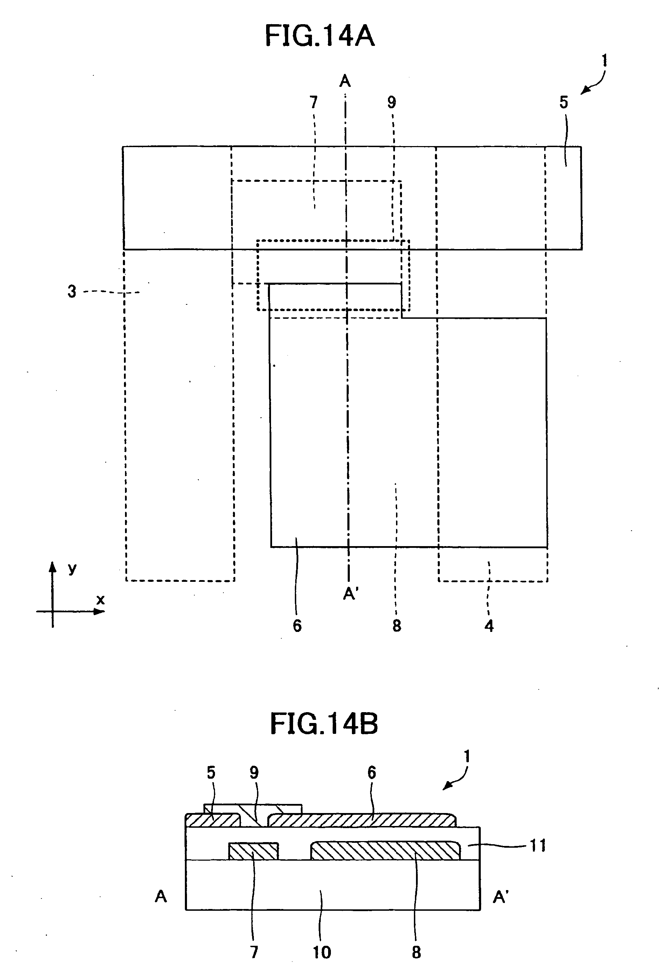

In the case where circuit components of the active matrix substrate are formed using the printing method, the set of circuit components including electrodes, a semiconductor, and an insulator is disposed one for each pixel to form a pattern. FIGS. 14A and 14B are diagrams showing a circuit configuration of a pixel of a typical active matrix substrate 1. FIG. 14A is a plan view and FIG. 14B is a cross-sectional view taken along line A-A' of FIG. 14A. In FIG. 14A, a source electrode 5 and a drain electrode 6 that are disposed in an upper layer are shown by solid lines; a gate electrode 7, a capacitor electrode 8, a gate signal line 3, and a common signal line 4 that are disposed in a lower layer at the lower side of a gate insulation film 11 of FIG. 14B are shown by dotted lines; and a semiconductor 9 is shown by heavy dotted lines.

In the active matrix substrate 1 having this circuit configuration, the gate electrode 7 and the capacitor electrode 8 are formed in the same layer. Although not shown in FIG. 14B, the two signal lines, namely, the gate signal line 3 connected to the gate electrode 7 and the common signal line 4 connected to the capacitor electrode 8 are also formed in the same layer of the same pixel.

Suppose that an electronic display device is formed using the active matrix substrate 1 having the circuit configuration shown in FIGS. 14A and 14B. In general, electronic devices are required to have high resolution to provide improved visibility. To achieve a facsimile level resolution of 200 ppi, for example, the required pixel size is 127 µm. In the case where the printing method is used to form the gate electrode 7, the gate signal line 3, the capacitor electrode 8, and the capacitor electrode 8 of FIGS. 14A and 14B, because the minimum pattern width is limited to a few tens of micrometers, the area of the gate electrode 7, the gate signal line 3, and the common signal line 4 accounts for 30 - 50% of the total area. This results in reducing the area for the capacitor electrode 8 and failing to provide sufficient capacity, thereby making it difficult to provide an electronic display that offers high performance. If the pixel size is further reduced to allow an increase in the resolution of the electronic display device, it is not possible to provide the area necessary for the capacitor electrode 8 and to form a precise circuit pattern.

Other than the methods that reduce the pixel size by forming a small drive circuit on the active matrix substrate, there are methods that reduce the pixel size by simplifying the drive circuit. According to these methods, a signal line is not provided for each pixel column or each pixel row but is provided one for two columns or two rows to provide necessary power and signals to the pixels.

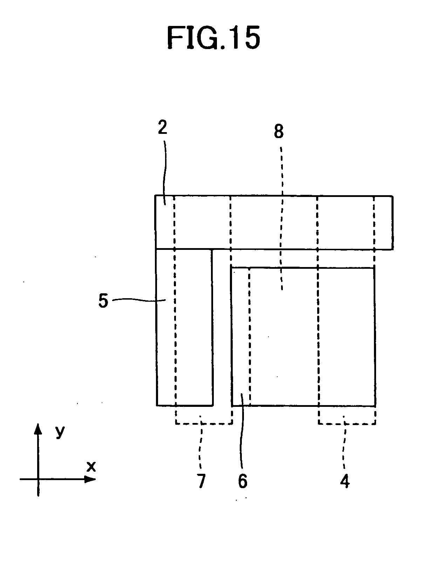

Japanese Patent Laid-Open Publication No. 2002-40990 (Patent Document 3) discloses, as a technique that increases the resolution of an active matrix substrate for use in an organic EL display device, a circuit configuration in which a source signal line is shared by two adjacent pixel columns. The power is selectively supplied to source electrodes of adjacent pixels via a pixel selection switch. This technique reduces the required number of source signal lines to half the required number of source signal lines of a related-art substrate, thereby increasing the aperture ratio of EL elements. It is to be noted that, in this circuit configuration of pixels of the active matrix substrate, a source signal line 2 is connected to a source electrode 5 in each pixel as shown in FIG. 15.

Japanese Patent Laid-Open Publication No. 2006-343768 (Patent Document 4) also discloses an active matrix substrate for use in an organic EL display device in which a source signal line is shared as a common feeder by adjacent two pixel columns. In this active matrix substrate, the power is supplied to adjacent pixels not via a switch but via transistors. The polarity of a drive current is inverted so that a current selectively flows through only one of the pixels according to the polarity of the transistors. A reduction in the number of source signal lines allows an increase in the light emitting area of the organic EL display device.

As described above, in the active matrix substrates of the organic EL display devices disclosed in Patent Documents 3 and 4, a source signal line is shared by the adjacent pixel columns (or pixel rows) to reduce the required number of source signal lines, thereby increasing the pixel area that can be used effectively and increasing the light emitting area. These active matrix substrates, however, require a switch or transistors so that the current from the source signal line is selectively supplied to the pixels. This undesirably increases the manufacturing steps. Moreover, a reduction in the number of source signal lines that supply power of the electronic display device alone cannot achieve the circuit configuration of a practical active matrix substrate. Therefore, it is desired to use the pixel area effectively while substantially reducing the required area and to reduce the pixel size without increasing the number of components of a drive circuit of each pixel of the active matrix substrate of the electronic display device.

JP 03 033724A discloses a liquid crystal display device in which thin film transistory and picture element electrodes are arranged on both sides of the gate line.

According to the invention there is provided an active matrix substrate including plural pixels arranged in a matrix form, wherein at least one of a source electrode, a gate electrode, and a capacitor electrode of pixel component electrodes of each of the pixels is shared by adjacent pixels,
the active matrix substrate having an insulation film, a plurality of drain electrodes and a plurality of conductive portions, characterised in that a through hole is formed in said insulation film that connects the plurality of drain electrodes to a corresponding plurality of pixel electrodes by said conductive portions, respectively, the pixel electrodes being formed over the drain electrodes with the insulation film interposed therebetween, the through hole being shared by the adjacent pixels, and said conductive portions in said through hole being insulated from each other.
FIG. 1A is a plan view illustrating two pixels of an active matrix substrate;
FIG. 1B is a cross-sectional view taken along line A-A' of FIG. 1A;
FIG. 1C is an equivalent circuit diagram of FIG. 1A;
FIG. 2 is a plan view illustrating two pixels of an active matrix substrate in which a semiconductor is not formed;
FIG. 3 is a plan view illustrating two pixels of an active matrix substrate in which a semiconductor is not formed;
FIG. 4 is a plan view illustrating four pixels of an active matrix substrate in which a semiconductor is not formed;
FIG. 5 is a plan view illustrating two pixels of an active matrix substrate in which a semiconductor is not formed;
FIG. 6 is a plan view illustrating two pixels of an active matrix substrate in which a semiconductor is not formed;
FIGS. 7A is a plan view illustrating two pixels of an active matrix substrate in which a semiconductor is not formed;
FIG. 7B is a cross-sectional view taken along line A-A' of FIG. 7A;
FIG. 8A is a plan view illustrating two pixels of an active matrix substrate;
FIG. 8B is a cross-sectional view taken along line A-A' of FIG. 8A;
FIG. 9A is a plan view illustrating two pixels of an active matrix substrate;
FIG. 9B is a cross-sectional view taken along line A-A' of FIG. 9A;
FIG. 10 is a plan view illustrating four pixels of an active matrix substrate;
FIG. 11 is a plan view illustrating eight pixels of an active matrix substrate according to an embodiment of the present invention;
FIG. 12 is a timing chart of operations of two pixels of an active matrix substrate according to an embodiment of the present invention;
FIGS. 13A - 13D are diagrams illustrating inkjet printing, wherein FIG. 13A is a cut-away side view showing an ink droplet being ejected; FIG. 13B is a plan view showing ejected ink droplets; FIG. 13C is a cut-away side view showing dried ink; and FIG. 13D is a plan view showing the dried ink;
FIG. 14A is a plan view illustrating a pixel of a related-art active matrix substrate;
FIG. 14B is a cross-sectional view taken along line A-A' of FIG. 14A;
FIG. 15 is a plan view illustrating a pixel of a related-art,active matrix substrate;
FIG. 16A is a plan view illustrating two pixels of a related-art active matrix substrate;
FIG. 16B is a cross-sectional view taken along line A-A' of FIG. 16A; and
FIG. 16C is an equivalent circuit diagram of FIG. 16A;

Exemplarily embodiments of the present invention are described below with reference to the accompanying drawings. Various changes and modifications to the embodiments herein chosen for purposes of illustration will readily occur to those skilled in the art. To the extent that such modifications and variations do not depart from the invention as defined by the claims, they are intended to be included within the scope thereof. The following description is exemplary, but is not restrictive, of the invention.

In an embodiment of the present invention, an active matrix substrate includes plural pixels arranged in a matrix form. At least one of a source electrode, a gate electrode, and a capacitor electrode of pixel component electrodes of each of the pixels is shared by the adjacent pixels. Corresponding to at least one of the source electrode, the gate electrode, and the capacitor electrode shared by the adjacent pixels, at least one of a source signal line, a gate signal line, and a common signal line may be shared by two adjacent pixel columns or pixel rows. Furthermore, a semiconductor and/or a through hole formed in an insulation film may be shared by the two - four adjacent pixels.

A combination of such circuit configurations makes it possible to substantially reduce the minimum area required for circuit components per pixel compared with that of a related-art active matrix substrate. In other words, it is possible to reduce the pixel size and increase the area in the pixel used for providing necessary functions.

Furthermore, in the case where the circuit components are shared by the adjacent pixels, even if the electrodes and signal lines are manufactured to have the same width as the width of electrodes and signal lines of the related-art active matrix substrate, their width in each pixel can be reduced to half the width in each pixel in the related-art active matrix substrate. Therefore, the active matrix substrate of the embodiment of the present invention can easily be formed using a printing method that has difficulty in forming a pattern of small width. Applying this technique to a multilayer structure can reduce requirements for the processing accuracy in the process of forming a pattern on the shared components.

With the active matrix substrate of the embodiment of the present invention, it is possible to produce a display device such as a liquid crystal display device and an organic EL display device having pixel size smaller than a related-art display device. An active matrix substrate of an embodiment of the present invention having the same pixel size as the related-art active matrix substrate can provide an increased capacitor electrode area and an increased light emitting area in the organic EL display device.

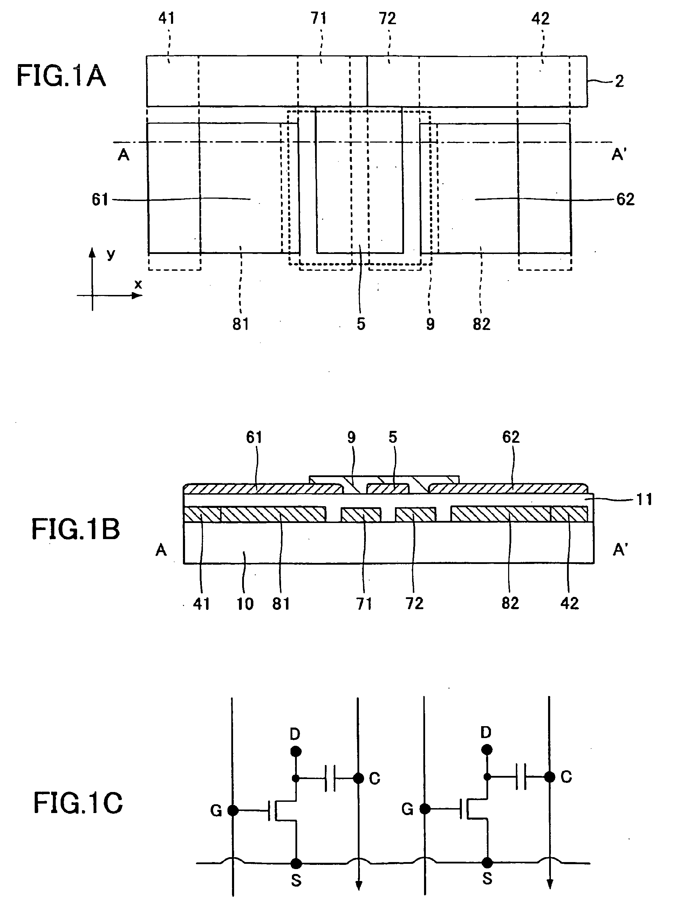

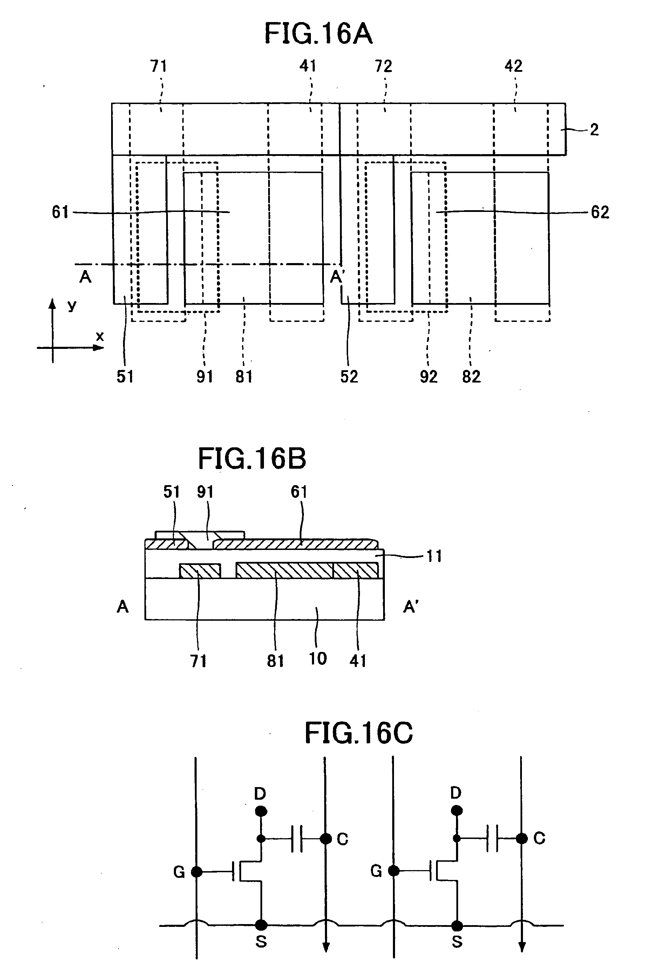

FIG. 1A - 1C illustrate a configuration of two pixels of an active matrix substrate. FIG. 1A is a plan view; FIG. 1B is a cross-sectional view taken along line A-A' of FIG. 1A; and FIG. 1C is an equivalent circuit diagram of FIG. 1A. In FIG. 1A, a semiconductor 9 is shown by heavy dotted lines; a source signal line 2, a source electrode 5, and drain electrodes 61 and 62 that are disposed in an upper layer are shown by solid lines; and gate electrodes 71 and 72, capacitor electrodes 81 and 82, and common signal lines 41 and 42 that are disposed in a lower layer at the lower side of a gate insulation film 11 of FIG. 1B are shown by dotted lines. As can be seen from FIGS. 1A and 1B, one source line 2, one source electrode 5, one semiconductor 9, two drain electrodes 61 and 62, two gate electrodes 71 and 72, two capacitor electrodes 81 and 82, and two common signal lines 41 and 42 are provided for the two pixels (1 pixel row by 2 pixel columns). In this embodiment, the gate electrodes 71 and 72 serve also as gate signal lines. In the active matrix substrate of this embodiment, the source electrode 5 and the semiconductor 9 are made integral with and shared by the two adjacent pixels. That is, the number of source electrodes 5 and the number of semiconductors 9 required for each pixel is reduced to half the number of source electrodes 5 and the number of semiconductors 9 required for each pixel of a related-art active matrix substrate of FIGS. 16A - 16C, which is described below. Because the source signal line 2 is supposed to be provided one for each pixel row, the single source signal line 2 is provided. The width of the source electrode 5 in each pixel is reduced to half the width of the source electrode 5 in each pixel of the related-art active matrix substrate. The width of the space between the adjacent pixels, which is necessary for the related-art active matrix substrate, can be reduced to half for each pixel.

FIGS. 16A - 16C show a configuration of two pixels of the related-art active matrix substrate for reference purposes. FIG. 16A is a plan view; FIG. 16B is a cross-sectional view taken along line A-A' of FIG. 16A; and FIG. 16C is an equivalent circuit diagram of FIG. 16A. In FIG. 16A, semiconductors 91 and 92 are shown by heavy dotted lines; a source signal line 2, source electrodes 51 and 52, and drain electrodes 61 and 62 that are disposed in an upper layer are shown by solid lines; and gate electrodes 71 and 72, capacitor electrodes 81 and 82, and common signal lines 41 and 42 that are disposed in a lower layer at the lower side of a gate insulation film 11 of FIG. 16B are shown by dotted lines. In the related-art active matrix substrate of FIGS. 16A - 16C, a set of circuit components including a source electrode and a semiconductor is provided one for each pixel. However, the equivalent circuit diagram of FIG. 1C is the same as the equivalent circuit diagram of FIG. 16C. That is, the above described active matrix substrate shown in FIGS. 1A - 1C provides the same effects as the effects provided by the related-art active matrix substrate of FIGS. 16A - 16C.

In both the above described active matrix substrate shown in FIGS. 1A - 1C and the related-art active matrix substrate shown in FIGS. 16A - 16C, there are shown three electrodes (the gate electrode, the drain electrodes, the source electrode) forming a transistor, the capacitor electrode that provides a capacity together with the source electrode, and the semiconductor that is in contact with both the drain electrode and the source electrode. However, when the source electrode and the drain electrode are viewed in the x direction, there are two lines and four spaces in the two pixels in FIG. 16A, while there are one line and three spaces in FIG. 1A (the drain electrodes are not counted as lines or spaces that are targets of width reduction, because the drain electrodes require a relatively large area). As described above, the above described active matrix substrate allows a reduction in the number of lines and spaces per pixel. Therefore, especially in the case of forming the source electrode and the drain electrode using a printing process, it is possible to significantly increase the resolution of the active matrix substrate.

While separate semiconductors are provided one for each pixel in the related-art active matrix substrate of FIG. 16A, a single semiconductor is provided that extends across the adjacent pixels in the active matrix substrate of FIG. 1A. In the active matrix substrate of FIG. 1A, a selection signal is sent to one of the two gate electrodes 71 and 72 disposed on the shared source electrode 5 and a non-selection signal is sent to the other one of the gate electrodes 71 and 72, thereby independently operating integrally formed transistors between the two adjacent pixels. That is, according to the configuration shown in FIG. 1A, there is no need to divide the semiconductor, so that requirements for the processing accuracy in the process of forming the semiconductor can be greatly reduced.

### <A method of manufacturing the active matrix substrate of the embodiment of the present invention>

A method of manufacturing the active matrix substrate of the embodiment of the present invention is the same as the method of manufacturing the related-art active matrix substrate. More specifically, an electrode layer, a signal line layer, an insulator layer, a semiconductor layer, etc., are formed, using a photolithographic method or a printing method, on a substrate on which various circuit components are to be formed. Because some of the circuit components can be shared by adjacent pixels, the active matrix substrate of the embodiment of the present invention can be manufactured using even a printing method that can only form a pattern of relatively great width. The printing methods include an inkjet printing method, a gravure method, a flexographic printing method, and a screen printing method. Among them, the inkjet printing method is preferably used for forming the electrodes. The screen printing method may be used for forming the insulator layer and the semiconductor.

### <Examples and Embodiments>

### (First example)

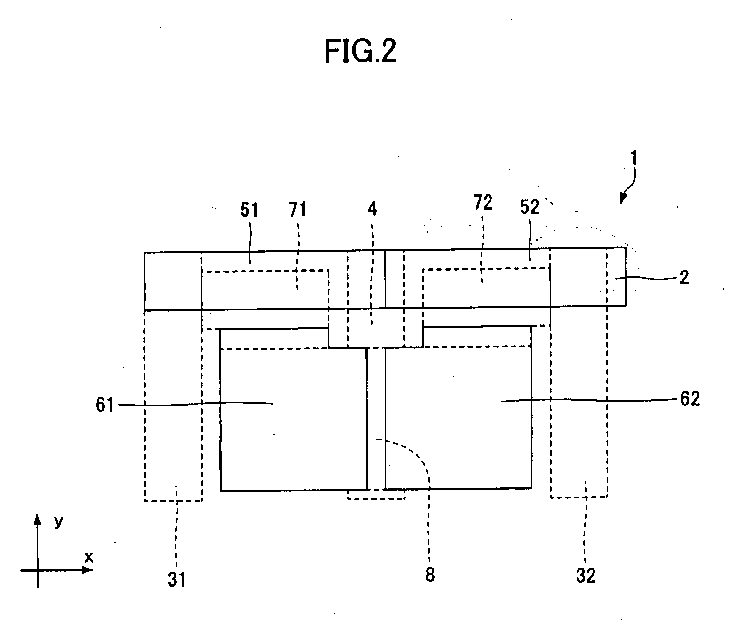

FIG. 2 illustrates an active matrix substrate 1 of a first example. FIG. 2 is a plan view showing signal lines and electrodes of two pixels of the active matrix substrate 1. In FIG. 2, source electrodes 51 and 52 and drain electrodes 61 and 62 forming an upper layer at cross section are shown by solid lines, and gate electrodes 71 and 72 and a capacitor electrode 8 forming a lower layer are shown by dotted lines as in FIG. 1A. Semiconductors that are disposed at the upper side of the gate electrodes 71 and 72 and configured to supply currents to the drain electrodes 61 and 62 from the source electrodes 51 and 52 in response to signals from the gate electrodes 71 and 72, respectively, are not shown for the sake of simplicity. In the drawings showing embodiments described below, solid lines and dotted lines are used in the same manner as in FIG. 2. A semiconductor (if illustrated) is shown by dotted lines. The active matrix substrate 1 of this example includes the source electrode 51 and 52, the drain electrodes 61 and 62, and the gate electrodes 71 and 72 for the two left and right pixels, respectively. The capacitor electrode 8 is shared by the two left and right pixels. A common signal line 4 connected to the capacitor electrode 8 is shared by the left and right pixels. In other words, the common signal line 4 is provided one for two pixel columns corresponding to the two left and right pixels of the active matrix substrate 1. In this embodiment, a source signal line 2 serves also as the source electrodes 51 and 52. In an alternative example, the source electrodes 51 and 52 may extend beyond the source signal line 2 to face the drain electrodes 61 and 62, respectively.

### (Second example)

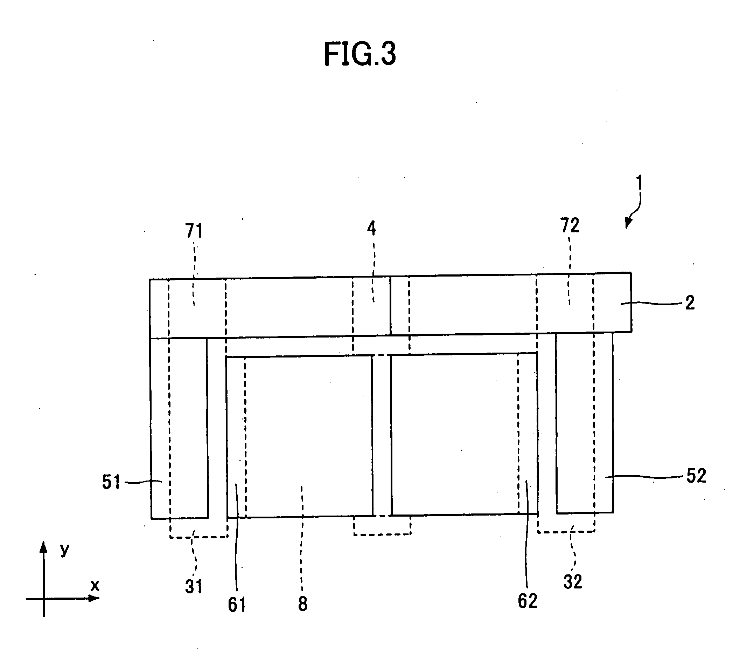

FIG. 3 illustrates an active matrix substrate 1 of a second example. FIG. 3 is a plan view showing signal lines and electrodes of two pixels of the active matrix substrate 1. A semiconductor is omitted as in FIG. 2. In the active matrix substrate 1 of this example, a source signal line 2, gate signal lines 31 and 32, and a common signal line 4 are arranged in the same manner as in the active matrix substrate 1 of the first example. However, source electrodes 51 and 52 are connected to the source signal line 2 at right angles near the upper sides of the gate signal lines 31 and 32 disposed at the left and right ends, respectively. Drain electrodes 61 and 62 face the source electrodes 51 and 52, respectively. A semiconductor (not shown) extending across the source electrode 51 and the drain electrode 61 and a semiconductor (not shown) extending across the source electrode 52 and the drain electrode 62 are disposed to form gate circuits at the left end and the right end of the two pixels, respectively. Because these gate circuit portions are disposed on the gate signal lines 31 and 32, the gate signal lines 31 and 32 serve also as gate electrodes, thereby eliminating the need to forming gate electrodes. In this embodiment, a capacitor electrode 8 and a common signal line 4 connected to the capacitor electrode 8 extend across the left and right pixels. That is, the capacitor electrode 8 is provided one for two pixels, and the common signal line 4 is provided one for two pixel columns.

### (Third example)

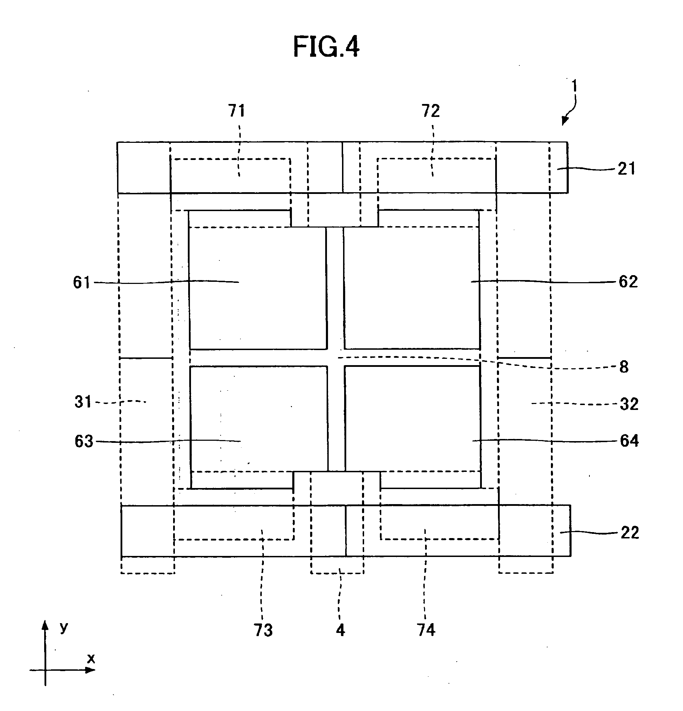

FIG. 4 illustrates an active matrix substrate 1 of a third example. FIG. 4 is a plan view showing signal lines and electrodes of four pixels of the active matrix substrate 1. A semiconductor is omitted as in FIG. 2. In this active matrix substrate 1, source signal lines 21 and 22 are disposed at the upper end and the lower end, respectively; gate signal lines 31 and 32 are disposed at the left end and the right end of the four pixels, respectively; and a common signal line 4 is disposed at the center and is parallel to the gate signal lines 31 and 32. In the active matrix substrate 1 of this example, each of the source signal lines 21 and 22 serves as a source electrode of two pixels in the same manner as in the active matrix substrate 1 of the first example. Gate electrodes 71 and 73 extend from the gate signal line 31 and are disposed under the left side of source signal lines 21 and 22, respectively. Gate electrodes 72 and 74 extend from the gate signal line 32 and are disposed under the right side of the source signal lines 21 and 22, respectively. Drain electrodes 61 - 64 are disposed on the corresponding four pixels to not overlap the source signal lines 21 and 22 and the gate signal lines 31 and 32. A semiconductor (not shown) extending across the source electrode 21 and the drain electrodes 61 and 62 and a semiconductor (not shown) extending across the source electrode 22 and the drain electrodes 63 and 64 are disposed over the gate electrodes 71 and 72 and the gate electrodes 73 and 74, respectively. That is, the active matrix substrate 1 of this example has a configuration similar to a configuration of two connected active matrix substrates 1 of the first example, one of which is rotated by 180 degrees. The active matrix substrate 1 of this embodiment is different from the active matrix substrate 1 of the first example in that a capacitor electrode 8 is shared by the four pixels. The common signal line 4 is disposed between two pixel columns and is parallel to the gate signal lines 31 and 32. The common signal line 4 is provided one for the two pixel columns.

According to the active matrix substrates 1 of the first - third examples, because the area of the capacitor electrode 8 can be increased, requirements for the processing accuracy in forming the capacitor electrode 8 using a printing process can be reduced. Further, according to the active matrix substrates 1 of the first and third examples, the area use efficiency can be increased in the x direction.

### (Fourth example)

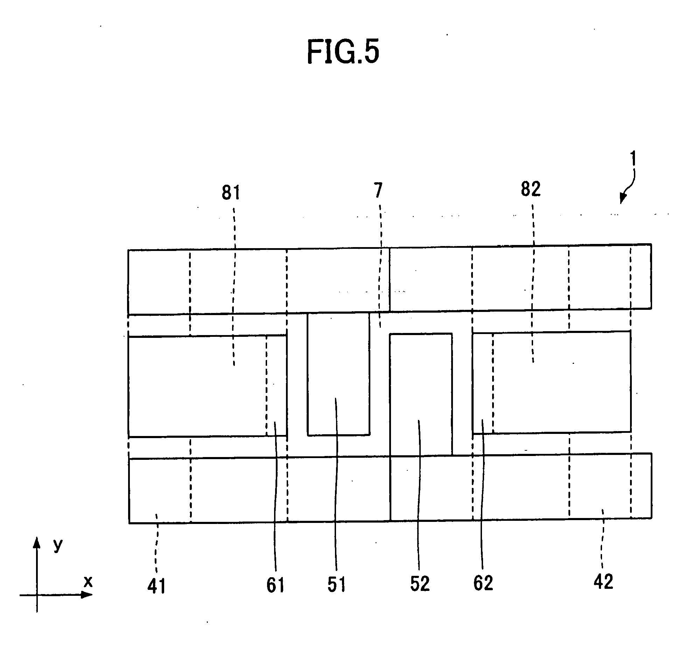

FIG. 5 illustrates an active matrix substrate 1 of a fourth example. FIG. 5 is a plan view showing signal lines and electrodes of two pixels of the active matrix substrate 1. A semiconductor is omitted as in FIG. 2. In this active matrix substrate 1, source electrodes 51 and 52 face drain electrodes 61 and 62, respectively, at the side where the pixels face each other. A gate electrode 7 serving also as a gate signal line is formed at the boundary between the two adjacent pixels. The gate electrode 7 is disposed under a portion between the source electrode 51 and the drain electrode 61 and a portion between the source electrode 52 and the drain electrode 62 in the direction orthogonal to a source signal line (not shown). In this active matrix substrate 1, the number of gate electrodes 7, serving also as gate signal lines, required for each pixel can be reduced to half the number of gate electrodes 7 required for each pixel of the related-art active matrix substrate. This allows a reduction in the cost of a gate signal control driver used for driving the active matrix substrate 1 and a reduction in the active matrix drive cycle.

### (Fifth example)

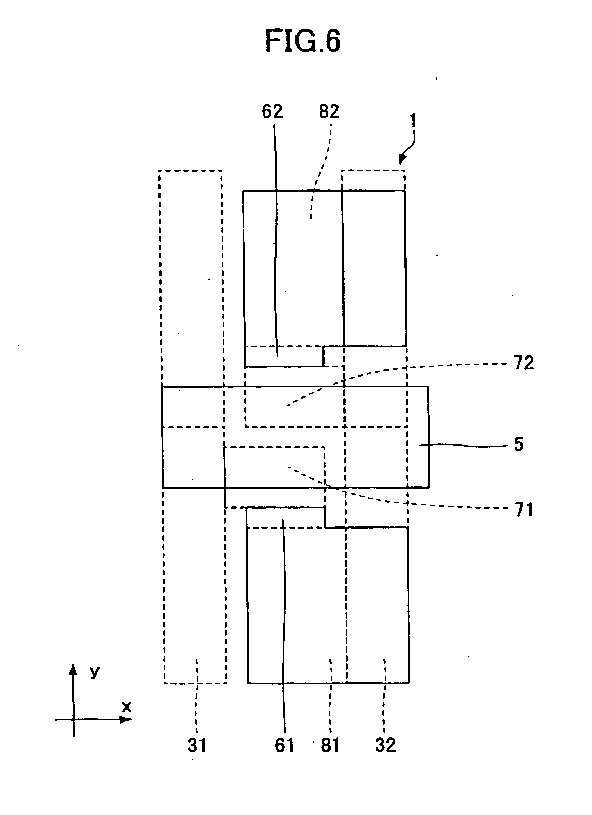

FIG. 6 illustrates an active matrix substrate 1 of a fifth example. FIG. 6 is a plan view showing signal lines and electrodes of two pixels of the active matrix substrate 1. A semiconductor is omitted as in FIG. 2. In this active matrix substrate 1, a source signal line 5 is formed at the boundary of the two pixels and serves as a source electrode of the two pixels. In this active matrix substrate 1, the number of source signal lines 5 required for each pixel can be reduced to half the number of source signal lines required for each pixel of the related-art active matrix substrate. This allows a reduction in the cost of a source signal control driver used for driving the active matrix substrate 1. Furthermore, this active matrix substrate 1 has one line and three spaces in the two pixels in the y direction and therefore has higher area use efficiency than the related-art active matrix substrate having one line and two spaces in one pixel.

### (Sixth example)

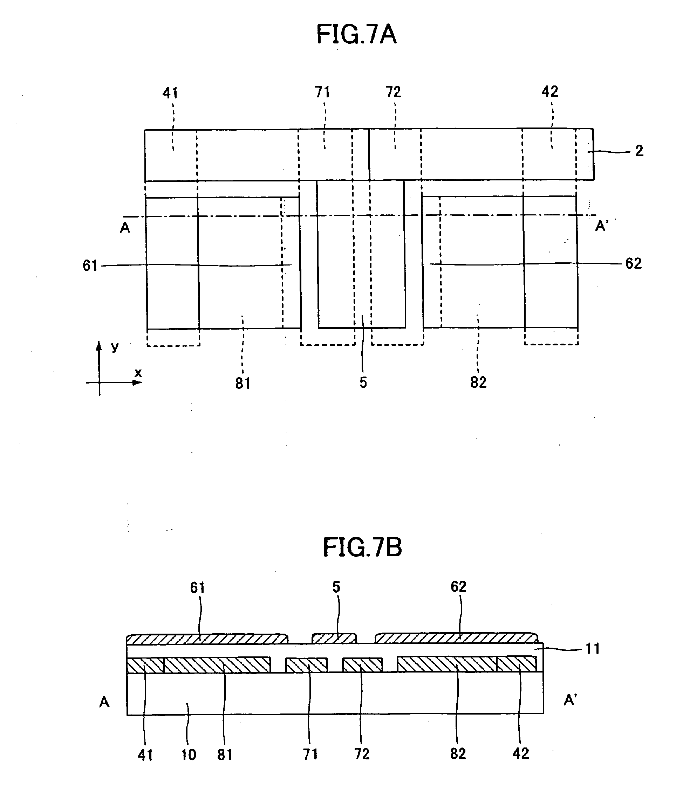

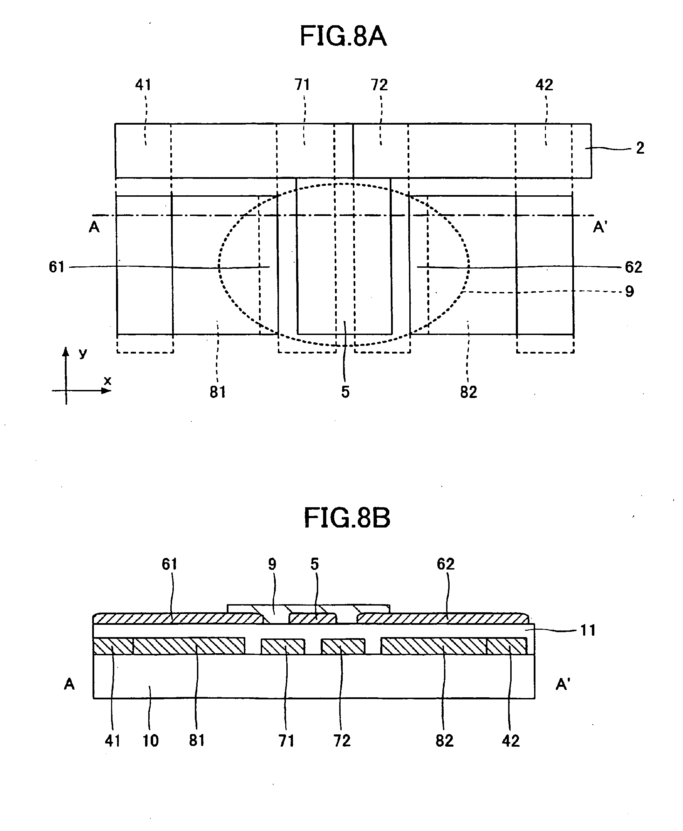

FIGS. 7A, 7B, 8A, and 8B illustrate an active matrix substrate 1 of a sixth example. FIGS. 7A and 8A are plan views showing signal lines and electrodes of two pixels of the active matrix substrate 1. A semiconductor 9 is omitted in FIGS. 7A and 7B as in FIG. 2, but is shown in FIGS. 8A and 8B. In this active matrix substrate 1, a source electrode 5 is shared by the adjacent pixels. The semiconductor 9 is also shared by the adjacent pixels. In this example, the number of source electrodes 5 required for each pixel is reduced to half the number of source electrodes 5 required for each pixel of the related-art active matrix substrate. The semiconductor 9 is provided one for each two pixels. Therefore, the processing accuracy requirements in the process of forming the semiconductor 9 can be reduced, thereby allowing easy production.

### (Seventh example)

A production example of an active matrix substrate of an example is described. First, a method of forming electrodes is described that involves steps 1 - 4.

### <Step 1>

First, a variable wettability material was applied onto the entire surface of a substrate using, for example, a spin-coating method and is dried to form an under layer on the substrate. The variable wettability material has wettability with respect to a functional liquid (described below) that varies in response to application of energy to the variable wettability material. The wettability as used here indicates how well the material repels or associates with the functional liquid. The material is in a functional liquid repelling condition when the contact angle is great, but is in a functional liquid wetting condition when the contact angle is small. The variable wettability material is a high-polymer material that has a hydrophobic group in a side chain forming a polymeric molecule. One of the most preferable compounds as the variable wettability material is a high polymer compound in which a side chain having a hydrophobic group is bonded to a main chain having a polyimide structure. If polyimide that provides excellent electric isolation is used, a fine pattern can be formed on an under layer that provides excellent electric isolation. Examples of a preferable hydrophobic group of the side chain include a fluoroalkyl group containing a fluorine atom and a hydrocarbon group not containing a fluorine atom. In the variable wettability material formed of such a high polymer compound, the bonds of the hydrophobic group are broken by application of energy using, for example, ultraviolet light, so that a hydrophilic group is formed at a region where the ultraviolet light is irradiated. Thus, the wettability with respect to the functional liquid varies to change the condition of the variable wettability material from the functional liquid repelling condition to the functional liquid wetting condition. In this example, a high polymer compound was used in which a side chain having a hydrocarbon group is bonded to a main chain having a polyimide structure.

### <Step 2>

Next, a functional fluid wettable region was formed by application of energy using ultraviolet light to the under layer. More specifically, a photomask was formed on the under layer to form a region that does not receive ultraviolet rays upon irradiation of ultraviolet rays. Although ultraviolet light was used for application of energy in this embodiment, heat, electron beams, plasma, etc., may alternatively be used. As mentioned above, application of energy using ultraviolet light separates the hydrophobic group of the high polymer compound side chain of the variable wettability material of the under layer, so that the wettability varies to change the condition of the variable wettability material from the functional liquid repelling condition to the functional liquid wetting condition. The photomask is a light shield formed of a material that blocks the ultraviolet light. The photomask is formed on the upper side of the under layer. The region onto which the ultraviolet light was irradiated without being blocked by the photomask changed from a functional liquid repellent region to a functional liquid wettable region. On the other hand, the region on the under layer that was not exposed to the ultraviolet light due to the photomask remained as a functional liquid repellent region without any change in the wettability.

### <Step 3>

Then, the functional liquid was selectively applied onto the functional liquid wettable region formed on the under layer using a functional liquid application method. Although an inkjet method was used as the functional liquid application method in this example, other methods such as a dispenser method may alternatively be used. Inkjet devices have long been used. A typical inkjet device includes a surface plate, a stage, an inkjet head, an X-axis direction movement mechanism connected to the inkjet head, a Y-axis direction movement mechanism connected to the stage, and a control unit. The stage supports a substrate and includes a substrate holding mechanism such as a suction mechanism. A functional-material-containing ink is applied onto the substrate using the inkjet head. A heat treatment mechanism may be provided that dries a solvent of the functional-material-containing ink applied on the substrate. The inkjet head includes plural inkjet nozzles arranged at regular intervals in the X-axis direction on its lower surface. The functional-material-containing ink is ejected from the inkjet nozzles onto the substrate held on the stage. The inkjet head also includes an inkjet mechanism, which may be of a piezo type. The functional liquid is ejected in response to application of voltage to piezoelectric elements in the inkjet head connected to the control device.

The X-axis direction movement mechanism includes an X-axis direction drive shaft and an X-axis direction drive motor. The X-axis direction drive motor may include a step motor. In response to supply of an X-axis direction drive signal from the control unit, the X-axis direction drive motor rotates the X-axis direction drive shaft and thereby moves the inkjet head in the X-axis direction. The Y-axis direction movement mechanism includes a Y-axis direction drive shaft and a Y-axis direction drive motor. In response to supply of a Y-direction drive signal from the control unit, the Y-axis direction drive motor rotates the Y-axis direction drive shaft and thereby moves the stage in the Y-axis direction. The control unit supplies an ejection control signal to the inkjet head. The control unit supplies also supplies an X-axis direction drive signal to the X-axis direction drive motor, and a Y-axis direction drive signal to the Y-axis direction drive motor. The control unit is connected to the inkjet head, the X-axis direction drive motor, and the Y-axis direction drive motor.

The inkjet device causes the inkjet head to eject liquid droplets onto the substrate held on the stage while moving the inkjet head and the stage relative to each other. A rotation mechanism that operates independently from the X-axis direction movement mechanism may be provided between the inkjet head and the X-axis direction movement mechanism. The rotation mechanism changes the relative angle between the inkjet head and the stage and thereby adjusts the pitch between the inkjet nozzles. A Z-axis direction movement mechanism that operates independently from the X-axis direction movement mechanism may be provided between the inkjet head and the X-axis direction movement mechanism. The Z-axis direction movement mechanism moves the inkjet head in the Z-axis direction and thereby adjusts the distance between the substrate and the nozzle surface. A rotation mechanism that operates independently from the Y-axis direction movement mechanism may be provided between the stage and the Y-axis direction movement mechanism. The rotation mechanism rotates the stage and thereby makes it possible to eject liquid droplets onto the substrate tilted at a desired angle.

The functional liquid contains the functional material. The functional liquid contains, for example, a conductor material, a semiconductor material, or insulator material dissolved or dispersed in a solvent. Especially, so-called nanometal inks containing metal microparticles, such as Au (gold), Ag (silver), Cu (copper), Al (aluminum), Ni (nickel), and Pd (palladium), dispersed in solvents; and functional liquids containing conductive polymers, such as PANI (polyaniline) and PEDOT (polyethylenedioxythiophene), dissolved in solvents may be used as a functional liquid containing a conductor material as the functional material. A nanometal ink containing Ag was used in this example.

### <Step 4>

After application of the functional liquid, the solvent component of the nanometal ink covering the functional liquid wettable region was evaporated. The solvent component may be dried and evaporated naturally or by heating. When the solvent component evaporated, the functional material that had been dispersed or dissolved in the functional liquid adhered to the functional liquid wettable region to form a functional material pattern. A convection heating oven was used in this example. After the ink was dry, the resulting functional material pattern was heated. This heat treatment removes a dispersant in the functional material pattern remaining after the drying process and thereby ensures good electrical contact between the microparticles. A convection heating oven heat treatment was used for this heat treatment as well, so that the electrode pattern having high electrical conductivity was formed.

Upon producing a multilayer structure as shown in, for example, FIGS. 7A and 7B using the above-described electrode forming process, conditions that enable formation of a fine electrode pattern were determined in advance. The piezo drive conditions of the inkjet device were optimized, and the volume of an ink droplet to be ejected was 8 pl. Under these conditions, the limits of the line width and the space width that do not cause a short circuit between adjacent pixels were examined while changing the line width and the space width. The results of the examination showed that the limits of the line width and the space width that do not cause a short circuit were 50 µm and 10 µm, respectively.

### <Forming an active matrix substrate>

The active matrix substrate of FIGS. 8A and 8B was formed using the above-described manufacturing process. First, the method of forming the active matrix substrate is described. First, referring to FIGS. 13A - 13D, the variable wettability material was applied onto the entire surface of a substrate 201 (10 in FIG. 8B). The variable wettability material was dried and thereby fixed on the substrate 201 to form an under layer 202. Although a glass substrate was used here as the substrate 201, substrates made of other materials such as silicon and plastic may alternatively be used.

Gate electrodes 71 and 72 and capacitor electrodes 81 and 82 were formed using the above-described steps 1 - 4. A gate insulation film 11 was applied on the entire surface of a substrate 10 using a spin-coating method. After the gate insulation film 11 was applied, a variable wettability material was further applied onto the entire surface of the substrate 10 using a spin-coating method and was dried to form an under layer. Then, source electrode 5 and drain electrodes 61 and 62 were formed using the above-described steps 1 - 4. In this manner, a multilayer structure (an active matrix substrate without a semiconductor) as shown in FIGS. 7A and 7B was formed. A multilayer structure as shown in FIG. 15 was also formed in the same manner.

In the obtained two types of multilayer structures, a matrix pattern of 100 elements by 100 elements was formed. The gate electrodes, the source electrodes, the drain electrodes, and the capacitor electrodes were designed based on the line width of 50 µm and the space width of 10 µm, and a pixel pitch of 127 µm was used that correspond to 200 PPI. It was possible to form the electrode pattern in each of the multilayer structures of the size described above without causing a short circuit. The drain electrode area in the electrode pattern of the multilayer structure of FIGS. 7A and 7B was greater than 1.4 times the drain electrode area in the electrode pattern of the multilayer structure of FIG. 15. This showed that sharing a source electrode by adjacent pixels is effective when forming a high resolution pattern using the printing method of which minimum pattern width is great.

Then, semiconductors 9 and 91 were formed on top of the two types of multilayer structures to form the active matrix substrates shown in FIGS. 8A and 8B and FIGS. 16A - 16C, respectively. In this embodiment, an inkjet method was used for device isolation of the semiconductors 91 and 91. Although other printing methods may be used, the inkjet method may preferably used to achieve a perfect circle or a shape close to an ellipse utilizing aggregation of droplets due to surface tension.

Thus, in the active matrix substrate of FIGS. 8A and 8B, it was possible to form the semiconductor 9 that is disposed on the source electrode 5 and extends across two drain electrodes 61 and 62, which are adjacent to the source electrode 5. Further, it was possible to achieve device isolation of the semiconductor 91 between adjacent pixels. On the other hand, in the active matrix substrate of FIGS. 16A - 16C, the design area of the semiconductor 91 was too small to achieve device isolation of the semiconductor 91 between adjacent pixels. Then, transistors of the two active matrix substrates were operated. In the active matrix substrate of FIGS. 8A and 8B, a selection signal was applied to the gate electrode 71; a non-selection signal was applied to the gate electrode 72; and a voltage was applied to the source signal line 2. Then, a current flowed through the drain electrode 61, while no current flowed through the drain electrode 62. That is, in the active matrix substrate of FIGS. 8A and 8B, it was possible to drive two transistors sharing the single source electrode 5 and the single semiconductor 9 independently from each other.

Then, an attempt was made to operate transistors in the other active matrix substrate of FIGS. 16A - 16C. In the active matrix substrate of FIGS. 16A - 16C, a selection signal was applied to the gate electrode 72, and a voltage was applied to the source signal line 2. Then, a current flowed through not only the drain electrode 62 but also the drain electrode 61. This current path results from the semiconductor 91, which was not properly formed, i.e., extends across the drain electrode 61 and the source signal line 2. Thus, it was not possible to operate the two transistors independently from each other. In the active matrix substrate of FIGS. 8A and 8B, it is possible to reduce the current flowing from the source signal line 2 to the drain electrode 61 by application of the non-selection signal to the gate electrode 71. As can be understood from the above description, the configuration of the active matrix substrate of this example can increase the electrode area use efficiency in the case where the printing method is used, and can reduce the processing accuracy requirements in the semiconductor element forming process.

### <Forming an active matrix substrate with pixel electrodes>

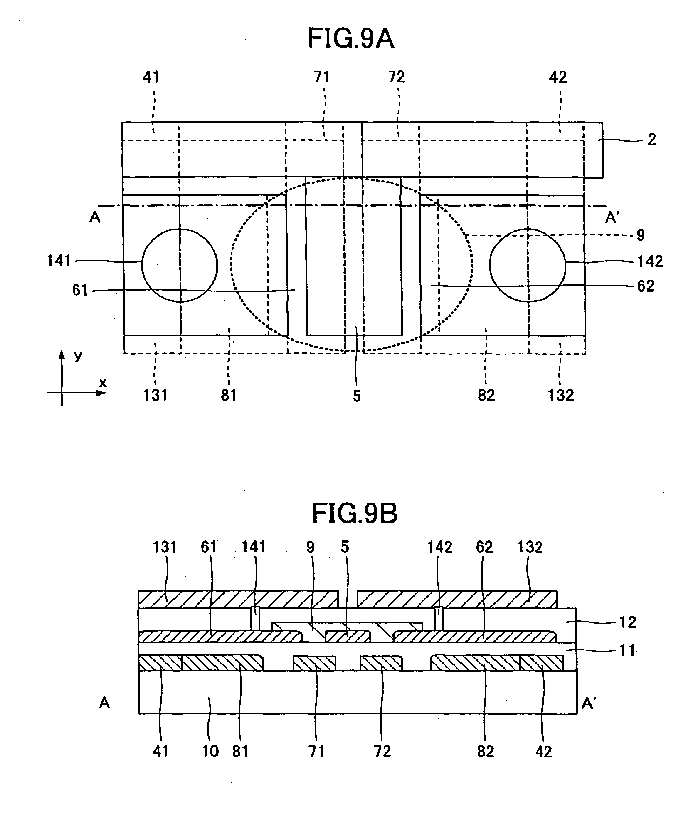

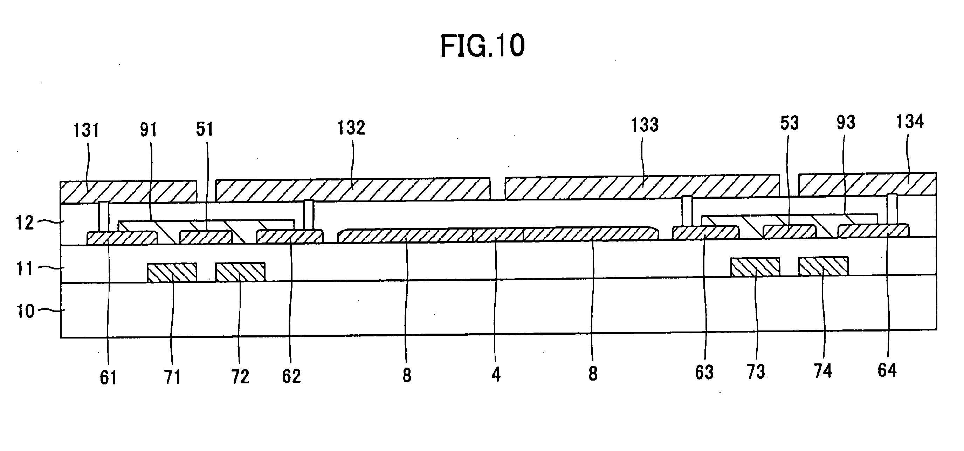

Referring to FIGS. 8A and 8B and FIGS. 9A and 9B, an interlayer insulation film 12 having through holes 141 and 142 and pixel electrodes 131 and 132 were formed on an active matrix substrate of FIGS. 8A and 8B using a screen printing method to form a multilayer structure of FIGS. 9A and 9B. The opening diameter of the through holes 141 and 142 was made 40 µm. The active matrix substrate of FIGS. 8A and 8B achieved a drain electrode area of 57 µm by 82 µm due to sharing of a source electrode 5, which the drain electrode area was greater than that of the active matrix substrate of FIGS. 16A - 16D. This configuration provided good contact between the pixel electrodes 131 and 132 and drain electrodes 61 and 62 via the through holes 141 and 142, respectively. This configuration achieved an active matrix substrate with pixel electrodes corresponding to a resolution of 200 PPI throughout the printing process. Although capacitor electrodes 81 and 82 are formed on the same layer as the layer on which gate electrodes 71 and 72 are formed in this embodiment, the capacitor electrodes 81 and 82 may be formed on the same layer as the layer on which a soured electrode 5 and the drain electrodes 61 and 62 are formed. In this case, a capacitor electrode 8 may alternatively be provided that is shared by pixels as shown in FIG. 10.

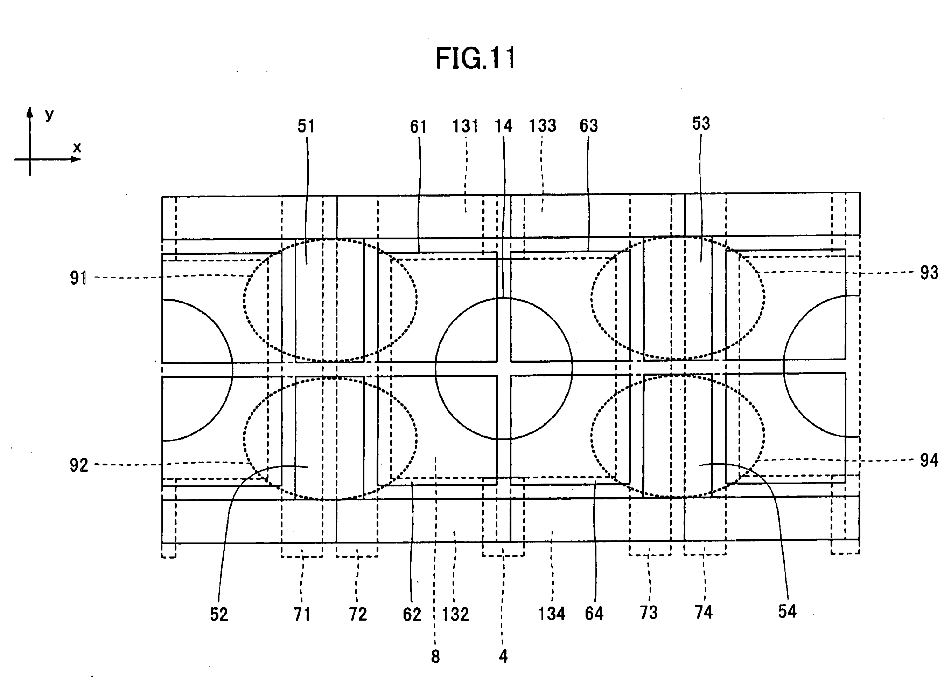

According to an embodiment of the invention, the active matrix substrate 1 of the third example shown in FIG. 4 is used to form a multilayer structure of FIG. 11 in which a single through hole 14 is shared by four pixels. In this case, although the through hole 14 formed in an interlayer insulation film (not shown) is shared by four pixels, four conductive portions within the through hole 14 that connect drain electrodes 61 - 64 to pixel electrodes 131 -134, respectively, insulate from each other.

The operations of an active matrix substrate of an embodiment of the present invention are described with reference to FIG.

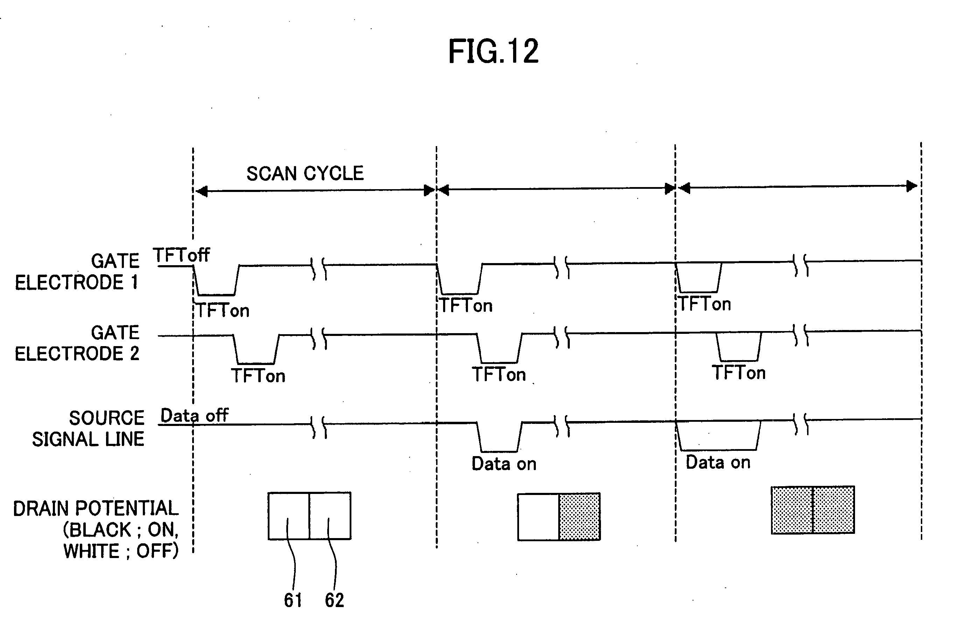

12. FIG. 12 is a timing chart of operations of the active matrix substrate according to the embodiment of the present invention, illustrating when a current flows through drain electrodes 61 and 62 in response to a voltage applied to a source signal line, which voltage is applied in response to signals input to gate electrodes 1 and 2. Unless a data signal is applied to the source signal line, even if pulse signals are input to the gate electrodes 1 and 2 to operate transistors, no current flows through the drain electrodes 61 and 62 (see left of FIG. 12). If a pulse signal is input to the gate electrode 1/2 to operate the transistor while a data signal is applied to the source signal line, a current flows through the corresponding drain electrode 61/62. In the case shown in the center of FIG. 12 where a data signal is applied to the source signal line only when a pulse signal is input to the gate electrode 2, a current flows through only the drain electrode 62 to have an electric potential. In the case shown in the right of FIG. 12 where a data signal is applied to the source signal line when pulse signals are input to the gate electrodes 1 and 2, a current flows through both the drain electrodes 61 and 62 to have electric potentials. In this way, the active matrix substrate of the embodiment of the present invention operates as a drive circuit of an electronic display device.

## Claims

1. An active matrix substrate including plural pixels (131, 132, 133, 134) arranged in a matrix form, wherein at least one of a source electrode (51, 52), a gate electrode (71, 72), and a capacitor electrode (81, 82) of pixel component electrodes of each of the pixels is shared by adjacent pixels,
the active matrix substrate having an insulation film, a plurality of drain electrodes (61, 62, 63, 64) and a plurality of conductive portions, **characterised in that** a through hole is formed in said insulation film that connects the plurality of drain electrodes to a plurality of corresponding pixel electrodes by said conductive portions, respectively, the pixel electrodes being formed over the drain electrodes with the insulation film interposed therebetween, the through hole being shared by the adjacent pixels, and said conductive portions in said through hole being insulated from each other.

2. The active matrix substrate as claimed in claim 1, **characterized in that** a semiconductor that supplies a current from the source electrode (51, 52) to the drain electrodes (61, 62, 63, 64) in response to a signal sent from the gate electrode is shared by the adjacent pixels.

3. The active matrix substrate as claimed in either claim 1 or claim 2, **characterized in that** at least one of a source signal line, a gate signal line, and a common signal line that are signal lines corresponding to pixel columns or pixel rows formed by the plural pixels is shared by two adjacent pixel columns or pixel rows.

4. An electronic display device,
**characterized by**:
one of the active matrix substrates of claims 1 through 3.

## Patentansprüche

1. Aktivmatrixsubstrat, das mehrere Pixel (131, 132, 133, 134) enthält, die in einer Matrixform angeordnet sind, wobei eine Source-Elektrode (51, 52) und/oder eine Gate-Elektrode (71, 72) und/oder eine Kondensatorelektrode (81, 82) von Pixelkomponentenelektroden jedes der Pixel durch benachbarte Pixeln gemeinsam genutzt werden,
wobei das Aktivmatrixsubstrat eine dünne Isolierschicht, mehrere Drain-Elektroden (61, 62, 63, 64) und mehrere leitende Abschnitte besitzt, **dadurch gekennzeichnet, dass** in der dünnen Isolierschicht ein Durchgangsloch ausgebildet ist, dass die mehreren Drain-Elektroden mit mehreren entsprechenden Pixelelektroden durch die entsprechenden leitenden Abschnitte verbindet, wobei die Pixelelektroden über den Drain-Elektroden so ausgebildet sind, dass dazwischen die dünne Isolierschicht vorhanden ist, wobei das Durchgangsloch durch die benachbarten Pixel gemeinsam genutzt wird, und wobei die leitenden Abschnitte in dem Durchgangsloch voneinander isoliert sind.

2. Aktivmatrixsubstrat nach Anspruch 1, **dadurch gekennzeichnet, dass** ein Halbleiter, der in Reaktion auf ein von der Gate-Elektrode gesendetes Signal einen Strom von der Source-Elektrode (51, 52) zu den Drain-Elektroden (61, 62, 63, 64) liefert, von den benachbarten Pixeln gemeinsam genutzt wird.

3. Aktivmatrixsubstrat nach Anspruch 1 oder Anspruch 2, **dadurch gekennzeichnet, dass** eine Source-Signalleitung und/oder eine Gate-Signalleitung und/oder eine gemeinsame Signalleitung, die Signalleitungen sind, die Pixelspalten oder Pixelzeilen entsprechen, die durch die mehreren Pixel gebildet werden, von zwei benachbarten Pixelspalten oder Pixelzeilen gemeinsam genutzt werden.

4. Elektronische Anzeigevorrichtung,
**gekennzeichnet durch**:
eines der Aktivmatrixsubstrate nach den Ansprüchen 1 bis 3.

## Revendications

1. Substrat de matrice active comprenant plusieurs pixels (131, 132, 133, 134) agencés sous la forme d'une matrice, dans lequel au moins l'une d'une électrode de source (51, 52), d'une électrode de grille (71, 72) et d'une électrode de condensateur (81, 82) d'électrodes de composants de pixel de chacun des pixels est partagée par les pixels adjacents,
le substrat de matrice active comportant un film isolant, une pluralité d'électrodes de drain (61, 62, 63, 64) et une pluralité de parties conductrices, **caractérisé en ce qu'**un trou traversant est formé dans ledit film isolant qui relie la pluralité d'électrodes de drain à une pluralité d'électrodes de pixel correspondantes par lesdites parties conductrices, respectivement, les électrodes de pixel étant formées sur les électrodes de drain, le film isolant étant interposé entre elles, le trou traversant étant partagé par les pixels adjacents, et lesdites parties conductrices dans ledit trou traversant étant isolées les unes des autres.

2. Substrat de matrice active selon la revendication 1, **caractérisé en ce qu'**un semi-conducteur qui délivre un courant de l'électrode de source (51, 52) aux électrodes de drain (61, 62, 63, 64) en réponse à un signal envoyé à partir de l'électrode de grille est partagé par les pixels adjacents.

3. Substrat de matrice active selon la revendication 1 ou la revendication 2, **caractérisé en ce qu'**au moins l'une d'une ligne de signal de source, d'une ligne de signal de grille et d'une ligne de signal commune qui sont des lignes de signaux correspondant à des colonnes de pixels ou des rangées de pixels formées par la pluralité de pixels est partagée par deux colonnes de pixels ou rangées de pixels adjacentes.

4. Dispositif d'affichage électronique, **caractérisé par** :
l'un des substrats de matrice active des revendications 1 à 3.
